# EUROPEAN PATENT SPECIFICATION

(11) **EP 0 851 944 B1**
(45) Date of publication and mention of the grant of the patent: **14.04.1999**
(21) Application number: 96928652.5
(22) Date of filing: 16.09.1996
(51) Int. Cl.: C25D 1/04

(54) **METHOD FOR PRODUCING ELECTRODEPOSITED COPPER FOIL AND COPPER FOIL OBTAINED BY SAME**
ELEKTROPLATTIERTE KUPFERFOLIE UND VERFAHREN ZU DEREN HERSTELLUNG
PROCEDE DE PRODUCTION DE FEUILLE DE CUIVRE DEPOSEE PAR ELECTROLYSE ET FEUILLE DE CUIVRE AINSI OBTENUE

(30) Priority: 22.09.1995 JP 244262/95; 26.04.1996 JP 106743/96
(43) Date of publication of application: 08.07.1998
(73) Proprietor: CIRCUIT FOIL S.A., L-9501 Wiltz (LU)
(72) Inventor: OTSUKA, Hideo Circuit Foil Japan Co., Ltd., Tochigi-ken (JP); STREEL, Michel, B-6662 Houffalize (BE); SUZUKI, Akitoshi Circuit Foil Japan Co., Ltd., Tochigi-ken (JP); WOLSKI, Adam, M., Edgewater Park, NJ 08010 (US)
(74) Representative: Weyland, J.J. Pierre
(86) International application number: PCT/IB96/00951
(87) International publication number: WO 97/11210

(56) References cited:
- EP-A- 0 632 146
- DE-A- 4 126 502
- CHEMICAL ABSTRACTS, vol. 99, no. 8, 22 August 1983 Columbus, Ohio, US; abstract no. 60929p, BURKAT: "electrolyte for producing copper foil" page 451; XP002019780 & SU,A,1 019 026 22 May 1983
- CHEMICAL ABSTRACTS, vol. 91, no. 4, 23 July 1979 Columbus, Ohio, US; abstract no. 29641z, WALIGORA: "copper foil which is mat on both sides" page 596; XP002019781 & PL,A,91 665 31 December 1977

## Description

The present invention relates to a method for producing electrodeposited copper foil capable of receiving fine patterns, more specifically, electrodeposited copper foil with which high etching factors can be obtained, and to copper-clad laminated boards, printed circuit boards and secondary battery cells incorporating such foil.

In addition, the present invention provides for producing untreated copper foil with both sides having flatter surfaces as compared to conventional copper foil, with the result that it can be used as flat cables or wires, as covering material for cables, as shielding material, etc. However, the electrodeposited copper foil produced according to the present invention is not restricted to these applications.

Electrodeposited copper foil for printed circuits is industrially produced by filling the gap between an insoluble electrode such as a lead electrode or a titanium electrode coated with a platinum group metal and a rotating cathode drum made of stainless steel or titanium arranged facing the insoluble electrode, with an electrolyte comprising an aqueous solution of copper sulfate, electric current being passed to these electrodes whereby copper is deposited on the cathode rotating drum: the deposited copper is then continuously peeled off the drum and coiled onto a storage reel.

In general, when an aqueous solution containing only copper ions and sulfate ions is employed as electrolyte, pinholes and/or micro porosities are produced in the copper foil due to an unavoidable admixture of dust and/or oil from the equipment, resulting in serious defects in practical use. Furthermore, the profile (mountain/valley) shape of the surface of the copper foil that is in contact with the electrolyte (the matte side) is deformed with the result that sufficient bond strength is not obtained when this copper foil is subsequently joined to the insulating substrate material. If the roughness of this matte side is considerable, insulation resistance between layers and/or circuit conductivity of a multilayer printed circuit board is lowered, or when pattern etching is performed after joining to the substrate material, copper may be left on the substrate, or undercutting of the circuit elements may occur; such phenomena have a severely adverse effect on various aspects of the performance of the circuit board.

In order to prevent the appearance of defects such as pinholes, chloride ions may be added for example to the electrolyte and the dust and/or oil may be removed by passing the electrolyte through a filter containing active carbon or the like. Also, in order to adjust the profile (mountain/valley) shape of the matte side and prevent micro porosities, it has long been the practice to add glue to the electrolyte and various organic and inorganic additives, apart from glue, have been proposed.

The process and production of electrodeposited copper foil for use in printed circuit boards is basically a plating technique, as can be seen from the fact that it involves arranging electrodes in a solution containing a copper salt, passing current between the electrodes and depositing copper on the cathode: additives used in copper plating can therefore often be applied in the form of additives during the production of electrodeposited copper foil for printed circuit board use. Glue. thiourea and molasses, etc. have long been known as brightening agents for copper plating. They may therefore be expected to have a so-called brightening effect or an effect in which the roughness of the matte side of the electrodeposited copper foil for printed circuit board use is decreased when these additives are employed in the electrolyte.

The specification of US Patent No. 5,171.417 discloses a method of producing electrodeposited copper foil using as additive an active sulfur-containing compound such as thiourea. However, the present situation is that, without modification, satisfactory performance is not obtained by use of such plating additives as additives for electrodeposited copper foil for printed circuit boards. This is because electrodeposited copper foil for printed circuit boards is produced with higher current densities than those used in ordinary plating techniques. This is necessary in order to improve productivity. The performance required for electrodeposited copper foil for printed circuit boards has become exceptionally demanding in recent years, and there is an increasing demand for copper foil with reduced roughness of the matte side without, however, impairing mechanical characteristics such as. in particular, the elongation properties.

Furthermore, with the incredible development of electronic circuit technology, including semiconductors and integrated circuits, in recent years there have of course been demands for further technical revolutions with regard to printed circuit boards on which these components are formed or mounted. Such demands call, for example, for a very high number of layers in multilayer printed circuit boards and for increasingly fine patterning.

With regard to the performance demanded from electrodeposited copper foil for printed circuit boards, in order to satisfy these requirements, one can list demands for improvements in inter-layer and inter-pattern insulation, profile lowering (decreased roughness) of the matte side for the prevention of undercutting when etching, and high-temperature elongation performance in order to prevent cracking due to thermal stress, and, in addition, high tensile strength in order to achieve dimensional stability of the printed circuit board. The demand for further lowering of the profile, in order to achieve finer patterning, is particularly strong.

Lowering of the profile of the matte side can be achieved by adding to the electrolyte large quantities of glue and/or thiourea, for example, as described above, but, on the other hand, as the amount of these additives is increased, there is an abrupt lowering of the room-temperature elongation rate and high-temperature elongation rate. In contrast, although copper foil obtained from an electrolyte to which additives have not been added possesses extremely high values for room temperature elongation and high-temperature elongation. the shape of the matte side is disrupted and its roughness is increased, making it impossible to maintain high tensile strength: furthermore, it is very difficult to produce foil in which these characteristics are stable. If the electrolysis current density is kept low, the roughness of the matte side is lower than in the case of electrodeposited foil produced at high current density, and elongation and tensile strength are also improved, but the drop in productivity is economically undesirable.

It is therefore not easy to achieve the further profile lowering, good room-temperature elongation and good high-temperature elongation and high tensile strength that are being demanded in recent years for electrodeposited copper foil for printed circuit boards.

A major reason why finer patterning could not be achieved with conventional electrodeposited copper foil was that the surface roughness was too pronounced.

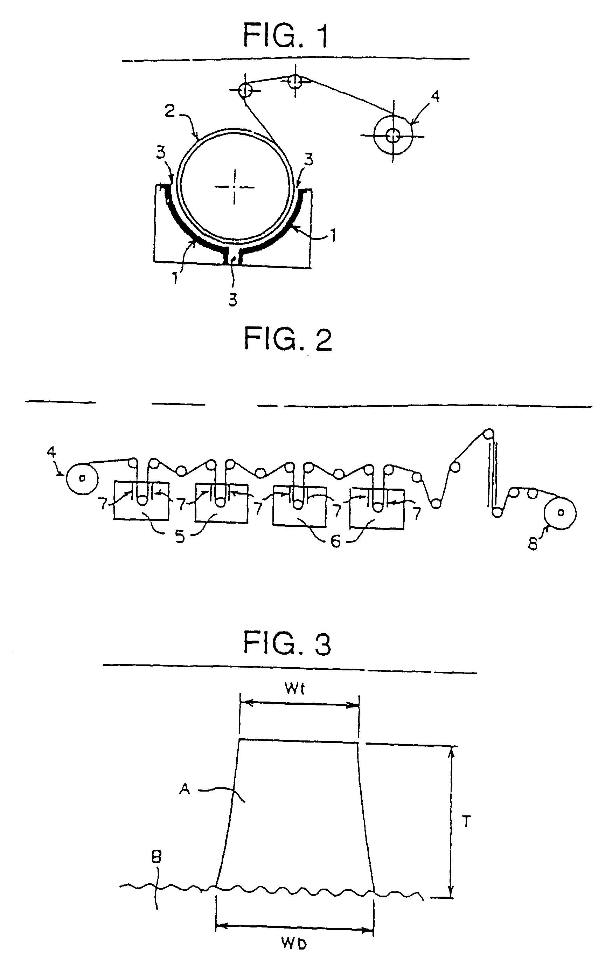

An electrodeposited copper foil can be generally produced by firstly using an electroforming cell as shown in Fig. 1 to produce a copper foil and then using a treater as shown in Fig. 2. the copper foil thus produced by electrodeposition being subsequently subjected to a bond enhancing treatment and a stain proofing treatment.

In the electroforming cell, an electrolyte 3 is passed through an apparatus comprising a drum-shaped cathode 2 (the surface of which is made of stainless steel or titanium) which is rotating and a stationary anode 1 (a lead or a titanium electrode covered by a precious metal oxide) which is provided opposite said cathode 2, and an electric current is passed through both electrodes to deposit copper on the surface of said cathode with a desired thickness and then the copper foil is peeled off from the surface of said cathode. The foil thus prepared is generally referred to as untreated copper foil.

In a subsequent step, in order to impart the performance needed for copper-clad laminated board, the untreated copper foil 4 is continuously subjected to electrochemical or chemical surface treatment by passing it through a treater as shown in Fig. 2. This treatment includes a step of deposition of copper nodules in order to enhance adhesion when the foil is laminated to the insulating resin substrate. This step is termed "bond enhancing treatment". Copper foil, after it has been subjected to these surface treatments, is termed "treated copper foil" and can be used in copper-clad laminated board.

The mechanical properties of the electrodeposited copper foil are determined by the properties of the untreated copper foil 4, and the etching performance, specifically the etching rate and uniform dissolving property, are also largely determined by the properties of the untreated copper foil.

A factor which has a large effect on the etching properties in the performance of the copper foil is its surface roughness. The effect of the roughness produced by the bond enhancing treatment on the face that is laminated to the insulating resin substrate is considerable. The factors affecting roughness of the copper foil can be broadly divided into two categories. One of these is the surface roughness of the untreated copper foil and the other is the method in which copper nodules are deposited on the surface subjected to the bond enhancing treatment. If the surface roughness of the original foil, i.e. the untreated copper foil is high, the roughness of the copper foil after the bond enhancing treatment becomes high. Also, in general, if the amount of copper nodules deposited is large, the roughness of the copper foil after the bond enhancing treatment becomes high. The amount of copper nodules deposited during the bond enhancing treatment can be controlled by means of the current flowing during the treatment, but the surface roughness of the untreated copper foil is largely determined by the electrolysis conditions when the copper is deposited onto the drum-shaped cathode as described above, in particular by the additives added to the electrolyte.

In general, the face of the untreated foil that contacts the drum, the so-called "shiny side", is comparatively smooth, but the other side, called the "matte side", has an uneven surface. Various attempts have been made in the past to make the matte side smoother. One example is the method of producing electrodeposited copper foil disclosed in US Patent No. 5,171,417 mentioned above in which an active sulfur-containing compound such as thiourea is used as an additive. However, although in this case the rough face is made smoother as compared to when a conventional additive such as glue is used, it is still rough in comparison with the shiny side, so that perfect effectiveness is not obtained.

Also, because of the relative smoothness of the shiny side, attempts have been made to laminate this bright surface onto the resin substrate by depositing copper nodules onto it, as disclosed in the Japanese patent publication number 94/270331. However, in this case, in order to allow copper foil etching, the photosensitive dry film and/or resist must be laminated to what is ordinarily the matte side: this leads to the drawback that the irregularity of this surface lowers the adhesion to the copper foil with the result that the layers easily become separated.

The present invention was made in order to solve the aforementioned problems of the prior art. It provides a method for producing copper foil having a high etching factor without lowering its peeling resistance and whereby fine patterning can be achieved without leaving copper particles at the root portions of the wiring pattern and having large high-temperature elongation and high tensile strength.

In general, a criterion of the fineness of patterning can be expressed by the etching factor (= 2 T / (Wb - Wt)) shown in Fig 3, in which B shows an insulating board. Wt is the top width of copper foil cross-section. Wb is the bottom width of copper foil cross-section and T is the thickness of cooper foil. Larger values of the etching factor correspond to a sharper shape of the circuit cross-section.

The invention discloses a method of producing copper foil by electrolysis using an electrolyte containing a 3-mercapto 1-propane sulfonate and a chloride ion characterized in that the electrolyte further contains a high-molecular weight polysaccharide. The invention also provides an electrodeposited copper foil wherein the surface roughness R_{Z} of the deposition surface of the untreated cooper foil ("matte side")is the same as or less than the surface roughness R_{Z} of the bright surface of this untreated copper foil ("shiny side"). Surface roughness R_{Z} means R_{Z} as specified by the definition of JIS B 0601-1994 "Indication of definition of surface roughness" 5.1. i.e. 10-point mean roughness R_{Z}).

This copper foil can be obtained by electrolysis using an electrolyte to which has been added a chemical compound having a mercapto group and apart from this at least one type of organic compound and a chloride ion.

The base additive of the combination according to this invention is 3-mercapto 1-propane sulfonate. 3-mercapto 1-propane sulfonates are compounds exemplified by HS(CH₂)₃SO₃Na, etc. This compound is not particularly effective in increasing the fineness of copper crystals on its own, but, by using it in conjunction with another organic compound, the copper crystals can be made fine and a plated surface with little irregularity can be obtained. The detailed mechanism of this is uncertain, but it is thought that these molecules may increase the fineness of the copper crystals by reacting with copper ions in the copper sulfate electrolyte, forming a complex, or by acting on the plating interface to increase the over-voltage, making it possible to form a plated surface with little irregularity.

It is to be noted that DE-C-4126502 discloses the use of 3-mercapto 1-propane sulfonate in an electrolytic bath for depositing copper coats on various objects such as on ornamental objects for giving them a shiny appearance or on printed circuit boards for reinforcing their conductive paths.

According to the present invention, the compounds to be used in combination with the mercapto-group-containing compound are high-molecular weight polysaccharides. High-molecular weight polysaccharides are hydrocarbons such as starch cellulose, vegetable gum. etc., which in general form colloids in water. Examples of such high-molecular weight polysaccharides that can be produced cheaply industrially include starches such as edible starch industrial starch, or dextrin, and cellulose such as the water-soluble cellulose ether disclosed in the japanese patent publication number 90/182890, i.e. sodium carboxymethyl cellulose or carboxymethyl hydroxy ethyl cellulose ether. Vegetable gums include gum Arabic or tragacanth gum.

These organic compounds increase the fineness of the copper crystals when used in combination with 3-mercapto 1-propane sulfonate, enabling a plated surface with no irregularities to be obtained. However, in addition to increasing the fineness of the crystals, these organic compounds act to prevent embrittlement of the copper foil that is produced. These organic compounds moderate the accumulation of internal stresses in the copper foil. thereby preventing tearing and curling of the foil on peeling off from the cathode drum: in addition, they improve elongation at room temperature and at high temperature.

A further type of organic compound that can be used in combination with the mercapto-group-containing compound and the high-molecular weight polysaccharide in the present invention is low-molecular weight glue. By low-molecular weight glue is meant glue as ordinarily produced with a molecular weight that has been reduced by decomposing the gelatine with an enzyme, acid or alkali. Commercially available examples are "PBF" made by Nippi Gelatine Inc. in Japan or "PCRA" made by Peter-Cooper Inc. in USA. Their molecular weights are less than 10.000 and they are characterized by extremely low jelly strength, due to their low molecular weight.

Ordinary glue or gelatine has the effect of preventing micro porosities and/or controlling roughness of the matte side and improving the shape thereof, but is subject to the problem that it adversely affects the elongation characteristics. However, it has been found that if, rather than the ordinary glue or gelatine that is commercially available, gelatine of low molecular weight is employed, micro porosity can be prevented and/or matte side roughness suppressed while improving the shape thereof without greatly sacrificing elongation characteristics.

In addition, if high-molecular weight polysaccharide and low-molecular weight glue are simultaneously added to the 3-mercapto 1-propane sulfonate, the high-temperature elongation is improved and micro porosities are prevented while a fine, uniformly irregular surface is obtained to a greatest degree than if these are used respectively independently.

Furthermore, in addition to the organic additives mentioned above, 0 chloride ions are added to the electrolyte. If there are no chloride ions at all in the electrolyte, it is impossible to obtain copper foil in which the profile of the rough surface has been lowered to the desired degree. Addition of a few ppm is beneficial, but, in order to produce low profile copper foil in a stable manner over a wide range of current densities, it is desirable to maintain the concentration in a range of 10 to 60 ppm. If the added amount exceeds 60 ppm, profile lowering is obtained, but there is no marked increase in the benefit as the added amount is increased: on the contrary, if an excess amount is added, dendritic electrodeposition occurs, lowering the limiting current density, which is undesirable.

As described above, by the joint addition to the electrolyte of 3-mercapto 1-propane sulfonate and high-molecular weight polysaccharide and/or low-molecular weight glue and a trace of chloride ions, the various characteristics that are sought for low profile copper foil in order to promote fine patterning can be achieved to a higher degree.

Furthermore, since the surface roughness R_{Z} of the deposited surface of the untreated copper foil (matte side) according to this invention is of the same order as or less than the surface roughness R_{Z} of the shiny side of this untreated copper foil, the surface-treated copper foil, after bond enhancing treatment of the deposited surface has been performed, has a lower profile than that of conventional foil; foil exhibiting large etching factors can thereby be obtained.

This invention is further described in detail below with reference to the Examples thereof which do not, however, restrict the scope of this invention.

### EXAMPLES 1, 3 AND 4

### (1) Foil production

The electrolyte of the composition shown in Table 1 (copper sulfate-sulfuric acid solution prior to addition of additives) was subjected to cleaning treatment by passing it through an active carbon filter. Electrolyte for foil production was then prepared by respective addition of sodium 3-mercapto 1-propane sulfonate. high-molecular weight polysaccharide constituted by hydroxy ethyl cellulose and low-molecular weight glue (molecular weight 3.000) and chloride ions to the concentrations shown in Table 1. The chloride ion concentration was in all cases adjusted to 30 ppm but the present invention is not restricted to this concentration, Untreated copper foil of thickness 18 µm was then produced by electrodeposition under the electrolysis conditions shown in Table 1, using as anode a precious metal oxide-coated titanium electrode and as cathode a titanium rotary drum, using the electrolyte that was thus prepared.

### (2) Evaluation of the roughness of the matte side and its mechanical characteristics

The surface roughness R_{Z} and Rₐ of the untreated copper foil of each of the embodiments obtained in (1) were measured using a surface roughness meter (type SE-3C, manufactured by KOSAKA KENKYUJO). (Surface roughness R_{Z} and Rₐ correspond to R_{Z} and Rₐ as defined in JIS B 0601-1994 "Definition and indication of surface roughness". Standard length l is 2.5 mm in the case of matte side surface measurement and 0.8 mm in the case of shiny side surface measurement.) The elongation at ordinary temperature in the longitudinal (machine) direction and after maintaining for 5 minutes at a temperature of 180°, as well as the tensile strength at each temperature were respectively measured using a tensile test device (type 1122 manufactured by Instron Co., England). The results are shown in Table 2.

### COMPARATIVE EXAMPLES 1, 2 AND 4

The surface roughness and mechanical properties of copper foil obtained by electrodeposition in the same way as in the Examples 1, 3 and 4 apart from the fact that electrolysis was conducted under the electrolysis conditions and with electrolyte of the composition shown in Table 1, were evaluated. The results are shown in Table 2.

**TABLE 1:**

| ELECTROLYTE COMPOSITION AND ELECTROLYSIS CONDITIONS | | | | | | | |
|---|---|---|---|---|---|---|---|
| Examples or Comparative Examples | Additives | | | | | Electrolysis conditions | |
| | MPS (ppm) | HEC (ppm) | glue (ppm) | thiourea (ppm) | Cl⁻ (ppm) | Current density (A/dm²) | Liquid temperature (°C) |
| Example 1 | 1.5 | 10.0 | - | - | 30 | 50 | 58 |
| Comparative Example 4 | 0.5 | - | 3.0 | - | | | |
| Example 3 | 0.8 | 3.0 | 6.0 | - | | | |
| Example 4 | 1.0 | 5.0 | 5.0 | - | | | |
| Comparative Example | - | - | 1.5 | 0.4 | | | |
| Comparative Example 2 | - | - | 4.0 | - | | | |

The electrolyte was copper sulfate/sulfuric acid solution. The concentrations used were:
- Copper:: 90 g/l
- Sulfuric acid:: 110 g/l
- MPS:: sodium 3-mercapto 1-propane sulfonate
- HEC:: hydroxy ethyl cellulose
- Glue:: In the case of Examples 2 to 4, low-molecular weight glue (molecular weight 3.000) was used and in the case of Comparative Examples 1 and 2, ordinary glue (molecular weight 60.000) was used.

**TABLE 2:**

| SURFACE ROUGHNESS AND MECHANICAL PROPERTIES OF UNTREATED COPPER FOIL | | | | | | | | |
|---|---|---|---|---|---|---|---|---|
| | Matte side roughness (µm) | | Shiny side roughness (µm) | | Room-temperature | | High temperature (180°C) | |
| | R_{Z} | Rₐ | R_{Z} | Rₐ | Tensile strength (kgf/mm²) | Elongation (%) | Tensile strength (kgf/mm²) | Elongation (%) |
| Example 1 | 1.3 | 0.30 | 2.0 | 0.40 | 37.2 | 18.1 | 18.6 | 26.7 |
| Comparative Example 4 | 2.1 | 0.32 | 2.1 | 0.35 | 33.6 | 11.7 | 19.5 | 19.7 |
| Example 3 | 1.1 | 0.20 | 1.8 | 0.35 | 35.3 | 19.8 | 19.0 | 24.6 |
| Example 4 | 0.6 | 0.14 | 1.4 | 0.23 | 33.8 | 14.4 | 18.7 | 25.8 |
| Comparative Example 1 | 3.3 | 0.40 | 2.0 | 0.37 | 36.8 | 9.0 | 20.3 | 8.0 |
| Comparative Example 2 | 4.8 | 0.70 | 2.1 | 0.32 | 33.7 | 9.5 | 20.5 | 2.0 |

In the case of Example 1, in which sodium 3-mercapto 1-propane sulfonate and hydroxy ethyl cellulose were added, the roughness of the matte side was quite small and the high-temperature elongation characteristic was excellent.

In the case of Examples 3 and 4, in which sodium 3-mercapto 1-propane sulfonate and hydroxy ethyl cellulose and low-molecular weight glue were added, the matte side roughness was even smaller than that obtained in Example 1.

In contrast, in the case of Comparative Example 1, in which thiourea and ordinary glue were added, although the matte side roughness was smaller than in the case of the prior art untreated copper foil, it was rougher than that of the untreated copper foil of the present invention: thus, only untreated copper foil having a matte side of higher roughness than that of the shiny side could be obtained. Furthermore, the high-temperature elongation was smaller in the case of this untreated copper foil.

In the case of Comparative Examples 2 and 4, the performance of the untreated copper foil obtained by electrodeposition using ordinary glue, respectively sodium 3-mercapto 1-propane sulfonate and ordinary glue, is shown for reference as examples of prior art copper foils.

Next, the bond enhancing treatment was carried out on the untreated copper foil shown in Examples 1, 3 and 4 and Comparative Examples 1, 2 and 4. The same bond enhancing treatment was performed on the shiny side of the untreated foil shown in Comparative Example 2. The bath composition and conditions for the treatment were as follows. After the bond enhancing treatment, surface-treated copper foil was produced by carrying out a further step of stain proofing treatment. The surface roughness of the copper foil was measured using a surface roughness meter (type SE-3C manufactured by KOSAKA KENKYUJO. Japan). The results are shown in Table 3. In Table 3. Examples 1, 3 and 4 and Comparative Examples 1, 2 and 4 show the results obtained by bond enhancing treatment on the matte side of the untreated copper foil of Examples 1, 3 and 4 and Comparative Examples 1, 2 and 4 of Table 2 respectively: Comparative Example 3 shows the results obtained by performing bond enhancing treatment on the bright surface of the untreated copper foil of Comparative Example 2 of Table 2.

| 1. | First-layer copper-plating conditions | |
|---|---|---|
| | Bath composition | metallic copper 20 g/l. sulfuric acid 100 g/l |
| | Bath temperature | 25°C |
| | Current density | 30 A/dm² |
| | Treatment time | 10 seconds |

| 2. Second-layer copper-plating conditions | | |
|---|---|---|
| | Bath composition | metallic copper 60 g/l. sulfuric acid 100 g/l |
| | Bath temperature | 60°C |
| | Current density | 15 A/dm² |
| | Treatment time | 10 seconds |

Copper-clad laminated board was produced by pressing under heat the copper foil obtained onto one side of a glass epoxy resin FR-4 substrate. The etching property was evaluated by the following "evaluation method".

### EVALUATION METHOD

Each copper-clad laminated board surface was washed and then liquid resist was applied uniformly in a thickness of 5 µm to this surface, which was then dried. Next, a test circuit pattern was superimposed on the resist and irradiation with ultraviolet light was carried out at 200 mJ/cm² using a suitable exposure device. The test pattern consisted of an arrangement of 10 parallel straight lines having a length of 5 cm, a line width of 100 µm and having 100 µm between the lines. Immediately after the exposure, development was performed, followed by washing with water and drying.

In this way, etching using an etching evaluation device was performed on the respective copper-clad laminated boards on which circuits were formed by means of the resist. The etching evaluation device provides for etching liquid to be sprayed from a single nozzle in a perpendicular direction onto a sample copper-clad laminated board erected vertically. For the etching liquid, a mixed solution of ferric chloride and hydrochloric acid (FeCl₃: 2 mol/l, HCl: 0.5 mol/l) was used: etching was conducted with a liquid temperature of 50°C, a spray pressure of 0.16 MPa, a liquid flow rate of 11/min, a separation distance between sample and nozzle of 15 cm. The spray time was 55 sec. Immediately after spraying, the sample was washed with water and the resist removed with acetone to obtain the printed circuit pattern.

For all the printed circuit patterns obtained, the etching factor at bottom width (root level) of 70 µm was measured. Concurrently, the peeling strength was measured. The results are shown in Table 3.

**TABLE 3:**

| SURFACE ROUGHNESS AFTER BOND ENHANCING TREATMENT AND ETCHING CHARACTERISTICS | | | | |
|---|---|---|---|---|
| Example or Comparative Example | Bond enhancing treatment Surface Roughness (µm) | | Etching factor | Peeling strength * (kgf/cm) |
| | R_{Z} | Rₐ | | |
| Example 1 | 1.8 | 0.3 | 3.9 | 1.14 |
| Comparative Example 4 | 2.2 | 0.5 | 3.8 | 1.17 |
| Example 3 | 1.6 | 0.3 | 3.9 | 1.16 |
| Example 4 | 1.1 | 0.3 | 4.1 | 1.13 |
| Comparative example 1 | 3.7 | 0.5 | 3.2 | 1.06 |
| Comparative example 2 | 7.3 | 1.1 | 2.3 | 1.64 |
| Comparative Example 3 | 4.6 | 0.7 | 3.5 | 1.13 |

| | | | | |
|---|---|---|---|---|
| * Measured with FR-4 substrate. | | | | |

Larger values of the etching factor mean that etching performance was evaluated as being better: the etching factor in the case of Examples 1, 3 and 4 was much larger than in the case of Comparative Examples 1 to 3.

In the case of Comparative Examples 1 to 2, the roughness of the matte side of the untreated copper foil was larger than in the case of Examples 1, 3 and 4, so the roughness after the bond enhancing treatment was also larger, resulting in a poor etching factor. In contrast, the roughness of the shiny side of the untreated copper foil of Comparative Example 3 was practically equal to that of the matte side of the untreated copper foil of Comparative Example 4. However, even though they were treater under the same conditions, the surface roughness of the bond enhancing treatment was smaller in the case of Comparative Example 4 and larger in the case of Comparative Example 3, which both belong to the prior art. The reason for this is thought to be that, in the case of the shiny side, since this is the face that is in contact with the titanium drum, any scratches on the drum are directly transferred to the shiny side, so that when subsequent bond enhancing treatment is performed. the copper nodules of the treatment become larger and coarser, with the result that the surface roughness after the final bond enhancing treatment ends up being larger; in contrast, with the matte side of copper foil according to the present invention, the surface obtained by electrodeposition in specular condition is extremely fine, so that when subsequent bond enhancing treatment is performed, the copper nodules of the treatment are made finer, resulting in a lower surface roughness after final bond enhancing treatment. This is even more marked in the case of Example 1, Example 3 and Example 4. The reason why a peeling strength of the same order as in Comparative Example 3 is obtained, even though the roughness of the surface subjected to bond enhancing treatment is much smaller, is believed to be that the bond enhancing treatment deposits finer copper particles, thereby increasing the surface area, so that the peeling strength is increased even though roughness is low.

It should be noted that, although the etching factor in Comparative Example 3 is close to that of Examples 1, 3 and 4, Comparative Example 3 is inferior to Examples 1, 3 and 4 in terms of the traces left behind on the substrate at the time of etching, because the roughness of the bond enhancing treatment is larger: in other words, it is inferior, not on account of poor high-temperature elongation, but for the reason given above.

As described above, with this invention, electrodeposited copper foil with a low profile can be obtained, yet has excellent room-temperature and high-temperature, elongation, and high tensile strength. The thus obtainec electrodeposited copper foil can be used as an inner or other layer copper foil for high-density printed circuit boards and also, because of its increased resistance to folding as electrodeposited copper foil for flexible printed circuit boards.

Furthermore, since it is flatter on both sides than conventional untreated copper foil, untreated copper foil obtained according to this invention can be used in electrodes for secondary battery, cells, as flat cables or wires, as covering material for cables, as shielding material, etc.

## Claims

1. Method of producing copper foil by electrolysis using an electrolyte containing a 3-mercapto 1-propane sulfonate and a chloride ion characterized in that the electrolyte further contains a high-molecular weight polysaccharide.

2. Method according to claim 1, characterized in that the electrolyte further contains a low-molecular weight glue having an average molecular weight of 10,000 or less.

3. Method according to any of the preceding claims, characterized in that the electrolyte contains sodium 3-mercapto 1-propane sulfonate.

4. An electrodeposited copper foil obtained by a method according to any of the preceding claims characterized in that its matte side has a surface roughness R_{Z} (as measured by JIS B 0601-1994) which is substantially the same as, or less than that of the shiny side.

5. An electrodeposited copper foil according to claim 4, characterized in that the foil is subjected to a surface bond enhancing treatment.

6. An electrodeposited copper foil according to claim 5, characterized in that the surface bond enhancing treatment is carried out by electrodeposition.

7. A copper-clad laminated board comprising an electrodeposited copper foil as claimed in any of claims 4 to 6.

8. A printed circuit board comprising an electrodeposited copper foil as claimed in any of claims 4 to 6.

9. A secondary battery cell including a component comprising an electrodeposited copper foil as claimed in any of claims 4 to 6.

## Patentansprüche

1. Verfahren zur Herstellung einer Kupferfolie durch Elektrolyse wobei ein Elektrolyt benutzt wird das ein 3-Mercapto-1-propansulfonat sowie ein Chloridion enthält dadurch gekennzeichnet, daß das Elektrolyt des weiteren ein Polysaccharid mit einem hohen Molekulargewicht enthält.

2. Verfahren gemäß Anspruch 1 dadurch gekennzeichnet, daß das Elektrolyt des weiteren Knochenleim mit einem niedrigen Molekulargewicht enthält, nämlich mit einem durchschnittlichen Molekulargewicht von 10.000 oder weniger.

3. Verfahren gemäß irgendeinem der vorhergehenden Ansprüche dadurch gekennzeichnet, daß das Elektrolyt Natrium-3-Mercapto-1-propansulfonat enthält.

4. Durch galvanische Abscheidung erzielte Kupferfolie, die nach einem Verfahren gemäß irgendeinem der vorhergehenden Ansprüche hergestellt worden ist, dadurch gekennzeichnet, daß die matte Seite eine Oberflächenrauheit R_{Z} (entsprechend der JIS B 0601-1994 gemessen) aufweist, welche im wesentlichen die gleiche oder geringer ist als diejenige der glänzenden Seite.

5. Durch galvanische Abscheidung erzielte Kupferfolie gemäß Anspruch 4, dadurch gekennzeichnet, daß die Folie einer die Haftfestigkeit der Oberflächen heraufsetzenden Behandlung unterzogen wird.

6. Durch galvanische Abscheidung erzielte Kupferfolie gemäß Anspruch 5, dadurch gekennzeichnet, daß die Behandlung zum Heraufsetzen der Haftfestigkeit der Oberflächen durch galvanische Abscheidung erfolgt.

7. Kupferkaschiertes Laminat mit einer durch galvanische Abscheidung erzielte Kupferfolie, wie sie in irgendeinem der Ansprüche 4 bis 6 beansprucht worden ist.

8. Leiterplatte mit einer durch galvanische Abscheidung erzielte Kupferfolie, wie sie in irgendeinem der Ansprüche 4 bis 6 beansprucht worden ist.

9. Sekundäre Batteriezelle mit einer Komponente die eine durch galvanische Abscheidung erzielte Kupferfolie aufweist, wie sie in irgendeinem der Ansprüche 4 bis 6 beansprucht worden ist.

## Revendications

1. Procédé de production d'une feuille de cuivre par électrolyse en utilisant un électrolyte contenant un 3-mercapto 1-propane sulfonate ainsi qu'un ion chlorure caractérisé en ce que l'électrolyte contient en outre un polysaccharide à poids moléculaire élevé.

2. Procédé selon la revendication 1, caractérisé en ce que l'électrolyte contient en outre une colle à bas poids moléculaire avec un poids moléculaire moyen égal ou inférieur à 10.000.

3. Procédé selon l'une quelconque des revendications précédentes caractérisé en ce que l'électrolyte contient du 3-mercapto 1-propane sulfonate de sodium.

4. Feuille de cuivre déposée électrolytiquement, obtenue par un procédé selon l'une quelconque des revendications précédentes, caractérisée en ce que son côté mat comporte une rugosité de surface R_{Z} (telle que mesurée d'après JIS B 0601-1994) qui est pratiquement la même que celle du côté brillant ou est inférieure à celle-ci.

5. Feuille de cuivre déposée électrolytiquement selon la revendication 4, caractérisée en ce que la feuille est soumise à un traitement de surface améliorant l'adhérence.

6. Feuille de cuivre déposée électrolytiquement selon la revendication 5, caractérisée en ce que le traitement de surface améliorant l'adhérence est réalisé par électrodéposition.

7. Stratifié cuivré comprenant une feuille de cuivre déposée électrolytiquement telle que revendiquée dans l'une quelconque des revendications 4 à 6.

8. Plaque de circuit imprimé comprenant une feuille de cuivre déposée électrolytiquement telle que revendiquée dans l'une quelconque des revendications 4 à 6.

9. Batterie (rechargeable) de type secondaire incluant un composant comprenant une feuille de cuivre déposée électrolytiquement telle que revendiquée dans l'une quelconque des revendications 4 à 6.
